# EUROPEAN PATENT SPECIFICATION

(11) **EP 2 360 999 B1**
(45) Date of publication and mention of the grant of the patent: **10.02.2016**
(21) Application number: 09828547.1
(22) Date of filing: 24.03.2009
(51) Int. Cl.: H05K 1/11, H05K 3/46, H01L 23/522, H01L 23/485, H01L 21/768

(54) **STRUCTURE OF CONDUCTIVE HOLES OF MULTILAYER BOARD AND MANUFACTURING METHOD THEREOF**
STRUKTUR AUS LEITENDEN BOHRUNGEN EINER MEHRSCHICHTIGEN PLATTE UND HERSTELLUNGSVERFAHREN DAFÜR
STRUCTURE DE TROUS CONDUCTEURS D UNE CARTE MULTICOUCHE ET SON PROCÉDÉ DE FABRICATION

(30) Priority: 03.11.2008 CN 200810176125
(43) Date of publication of application: 24.08.2011
(73) Proprietor: Princo Corp., Hsinchu 300 (TW)
(72) Inventor: YANG, Chih-Kuang, Hsinchu City 300 Taiwan (CN)
(74) Representative: Petraz, Gilberto Luigi
(86) International application number: PCT/CN2009/070976
(87) International publication number: WO 2010/060286

(56) References cited:
- WO-A1-98/19337
- WO-A1-98/27588
- CN-A- 1 763 941
- CN-C- 1 146 043
- JP-A- 9 283 624
- JP-A- H09 283 624
- US-A- 5 322 816
- US-A- 5 427 980
- US-A- 5 427 980
- US-A1- 2006 108 143

## Description

### BACKGROUND OF THE INVENTION

### 1. Field of the Invention

The present invention generally relates to a via structure in a multi-layer substrate and the manufacturing method thereof, and more particularly to a via structure in a flexible multi-layer substrate and the manufacturing method thereof.

### 2. Description of Prior Art

Miniaturization of all electronic products is an inevitable trend in this modern world. While the scales of the semiconductor chips continuously get smaller, the scale of the related technology for packaging needs to be microminiaturized to follow the scale of the semiconductor chip is also inevitably getting smaller. Today, because the routing density of integrated circuits has been greatly increased, using a multi-layer substrate as being a package substrate, a print circuit board, a flexible package substrate or a flexible print circuit board and for obtaining a high performance integration system must be developed consequentially. Particularly, the flexible multi-layer substrate should be mentioned to become efficiently adoptable in variable electronic products for miniaturization. Generally, the metal lines and the via structures of the multi-layer substrate are manufactured by etching or semi-additive methods according to prior arts. The higher the circuit routing density increases, the finer the metal line and the via structure are requested. The fine-pitch products well known in the related industry field are generally meant to be high integration products.

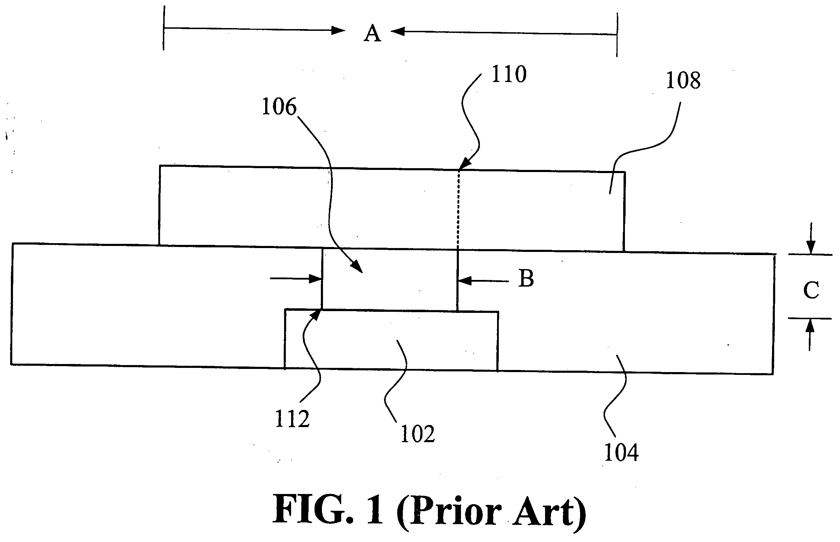

Please refer to FIG. 1, which depicts a diagram of a via structure in a multi-layer substrate according to prior arts. FIG. 1 only shows related parts of the multi-layer substrate with the via structure. The multi-layer substrate comprises a metal layer 102 as being the lower metal lines. A dielectric layer 104 covers metal layer 102. The via 106 is formed by laser or mechanical drill. The via 106 has a vertical via wall. After the via 106 is formed and metal material is filled therein. With a metal layer 108 as a via land, the electrical connection between metal layer 102 and other upper metal layers of the dielectric layer 104 is objected to be established. When the multi-layer substrate comprises such kind of via structure and is applied to be bended. The metal layer 108 at the position 110 which is connected with the metal material in the via 106 and aligned to the edge of the dielectric layer 104 can be easily peeled off or even broken. Same issue can frequently happen at the position 112 where the metal layer 102 and the metal material in the via 106 connect.

The via structure is an important part for the electrical connection between different metal layers in the multi-layer substrate. When the via structure is manufactured in the flexible multi-layer substrate, and more particularly in the frequently bended area of the flexible multi-layer substrate, there is higher possibility that the position 110 of the metal layer 108 aligned to the edge of the dielectric layer 104 peels off or even breaks. The position 112 connecting the metal layer 102 and the metal material in the via 106 also peels off or even breaks with higher possibility, similarly. Meanwhile, the via land size A of such via structure has to be larger than the via diameter B. In consequence of limitation about the via pitches and metal line pitches of the multi-layer substrate, application to the high integration products will be failed.

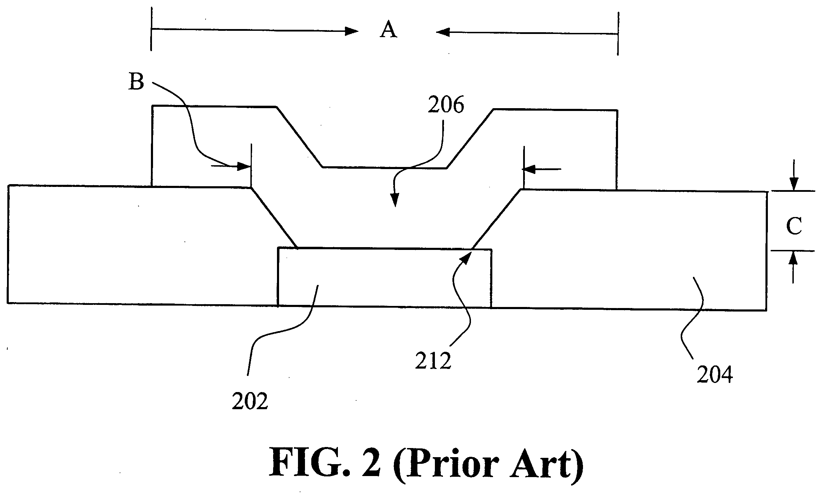

Please refer to FIG. 2, which depicts a diagram of another via structure in a multi-layer substrate according to prior arts. Similarly, a metal layer 202 is formed and prepared for manufacturing the lower metal lines. A dielectric layer 204 covers metal layer 202 and includes the via 206. After the via 206 is formed and then via land is formed therein to establish the electrical connection between metal layer 202 and other metal layers above the dielectric layer 204. When the multi-layer substrate is frequently bended, the position 212 connecting the metal layer 202 and via land peels off with higher possibility. Especially when the via depth C becomes deeper, the possibility of the position 212 peeling off may be almost the same as that of the position 112 peeling off shown in FIG. 1. Meanwhile, as the via structures of the multi-layer substrate are manufactured by etching or semi-additive methods according to prior arts, the process tolerance has to be further considered (More details will be described later). Therefore, the via land size A of such kind of via structure has to be larger than the via diameter B. Still, in consequence of limitation about the via pitches and metal line pitches of the multi-layer substrate, further application to the higher routing density today cannot be realized.

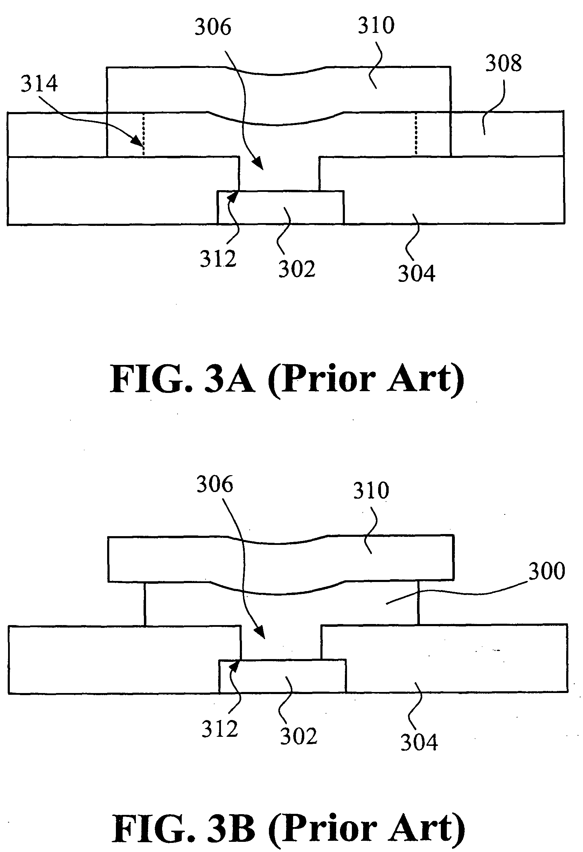

Please refer to FIG. 3A and FIG. 3B, which depict diagrams of manufacturing a via structure by etching method according to prior arts at the same time. A metal layer 302 is formed in advance when the via structure is manufactured by etching method. The dielectric layer 304 is formed and covers the metal layer 302. Then, a via 306 is formed. Next, a metal layer 308 for manufacturing the via land 300 is formed to fill in the via 306. Meanwhile, the metal layer 308 also covers the dielectric layer 304. Afterward, a photoresist layer 310 is coated at the position of manufacturing via land. After the photoresist layer 310 is coated, the uncovered metal layer 308 with the photoresist layer 310 is etched and removed.

Because the etching is isotropic, not only the uncovered metal layer 308 is etched but the side surface of the via land is also etched. For example, the via land will be etched to shrink back to the position of dot lines 314. Therefore, an undercut structure happens to the via land as shown in FIG. 3. If the etching method is employed to manufacture the via structures of the multi-layer substrate, the photoresist layer 310 cannot determine the via land size exactly. Accordingly, the via land size cannot be further minified because the design tolerance of the etching process has to be considered. As finer the metal lines and sizes of the via structures are required, the etching method has limitation and cannot satisfy coming demands of the multi-layer substrate products.

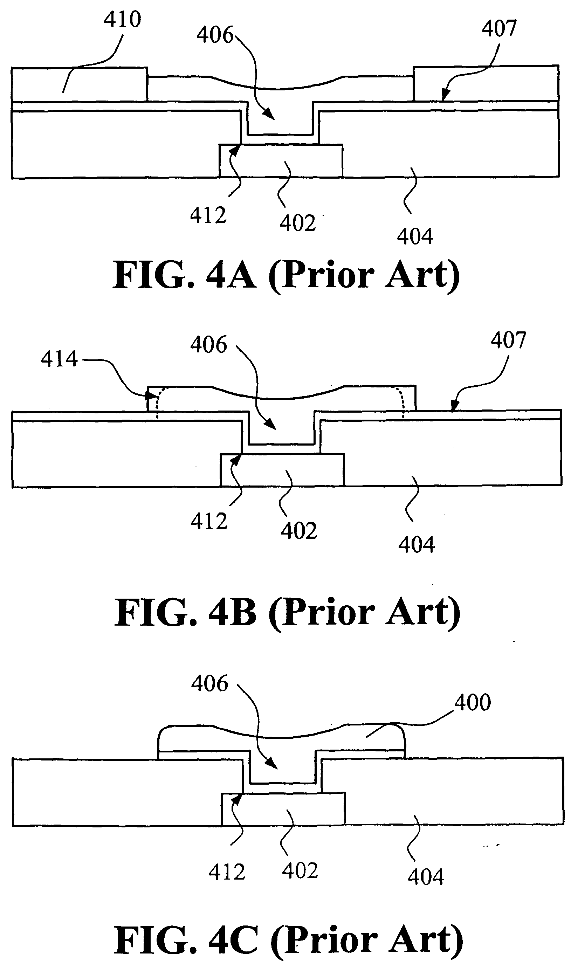

Pleas refer to FIG. 4A to FIG. 4C, which depict diagrams of manufacturing a via structure by SAP, semi-additive process. First, a metal layer 402 is formed and then the dielectric layer 404 is formed to cover the metal layer 402 when the via structure is manufactured by etching method. Then, a via 406 is formed. Next, a seed metal layer 407 is formed. Afterward, a photoresist layer 410 is coated except the position of manufacturing via land. And then, a metal layer is formed to fill in the position of the via land. The seed metal layer 407 except the position of the via land 400 is removed by the etching method after the photoresist layer 410 is removed as shown in FIG. 4B and FIG. 4C to finish the process of manufacturing the via structure.

However, the via land 400 will be etched and shrinks back to the position of dot lines 414 as shown in FIG. 4B while the seed metal layer 407 except the position of the via land 400 is removed. Consequently, the via land 400 which's size is smaller than what the photoresist layer 410 originally defines is formed as shown in FIG. 4C. Similar drawback appears, if the semi-additive process method is employed to manufacture the via structures of the multi-layer substrate, the photoresist layer 410 cannot determine the via land 400 size exactly. Because the design tolerance of the semi-additive process has to be further considered and via land size accordingly cannot be minified. As finer the metal lines and sizes of the via structures are required strictly, the semi-additive method also has limitation and cannot satisfy coming demands of the multi-layer substrate products today and in the near future.

In conclusion, there is a need to develop a via structure in a multi-layer substrate and manufacturing method which the via land is inside the via to diminish the possibility of aforesaid peeling off or even breaking. The manufacturing tolerances of metal lines and via lands of the multi-layer substrate can be further reduced. Therefore, routing density can be increased and an electrical system can be easily integrated in more functions on a substrate. Moreover, the via structure and manufacturing method thereof can be applied to the flexible multi-layer substrates and raise the reliability of the package substrates. JP 09283624A, WO 9827588A, and US 5427980A are related prior arts for this field.

### SUMMARY OF THE INVENTION

An objective of the present invention is to provide a via structure in a multi-layer substrate and manufacturing method thereof to apply in the field of manufacturing package substrates, print circuit boards, flexible package substrates and flexible print circuit boards. The via land of the present invention is smaller than the via therefore, to decrease the pitches among the vias and the metal lines (fine-pitch) to increase the routing density of the aforesaid substrates and print circuit boards.

Another objective of the present invention is to a via structure in a multi-layer substrate and manufacturing method thereof to apply in frequently bended areas of the flexible package substrates and the flexible print circuit boards to promote the reliabilities thereof.

The via structure in the multi-layer substrate of the present invention comprises a first metal layer, a dielectric layer and a second metal layer. The first metal layer has an upper surface. The dielectric layer covers the first metal layer in which a via is opened to expose the upper surface and the via has an inclined wall with an upper edge. The second metal layer is formed in the via and contacts the upper surface and the inclined wall. A contacting surface of the second metal layer has a top line lower than the upper edge of the inclined wall. Alternatively, the second metal layer can be formed on the dielectric layer as being a metal line simultaneously as formed in the via as being a pad. The metal line and the pad are connected electronically. The aforesaid metal second layer can be formed in the via and on the dielectric layer by a metal lift-off process.

The present invention also provides a manufacturing method of a via structure in a multi-layer substrate. The manufacturing method comprises steps below:
forming a first metal layer having an upper surface;
forming a dielectric layer to cover the first metal layer;
opening a via to expose the upper surface of the first metal layer and the via has an inclined wall with an upper edge;
coating at least one photoresist layer on a surface of the dielectric layer and the upper surface of the first metal layer;
proceeding a photolithography process to the photoresist layer;
removing the photoresist layer in the via;
forming a second metal layer in the via and on the photoresist layer coated on the surface of the dielectric layer, wherein the second metal layer in the via contacts the upper surface and the inclined wall; and
removing the photoresist layer on the surface of the dielectric layer and the second metal layer formed on the photoresist layer.

Specifically, the via structure and the manufacturing method of the present invention can be applied in the field of package substrates. Meanwhile, the via structure and the manufacturing method can be employed in the technical field of manufacturing print circuit boards and flexible package substrates.

### BRIEF DESCRIPTION OF THE DRAWINGS

FIG. 1 depicts a diagram of a via structure in a multi-layer substrate according to prior arts.
FIG. 2 depicts a diagram of another via structure in a multi-layer substrate according to prior arts.
FIG. 3A and FIG. 3B depict diagrams of manufacturing a via structure by etching method according to prior arts.
FIG. 4A to 4C depict diagrams of manufacturing a via structure by semi-additive process.
FIG. 5 depicts a diagram of a first embodiment of a via structure in a multi-layer substrate according to the present invention.
FIG. 6 depicts a diagram of a second embodiment of a via structure in a multi-layer substrate according to the present invention.
FIG. 7 depicts a vertical view diagram of the second embodiment of the via structure in the multi-layer substrate according to the present invention.

### DETAILED DESCRIPTION OF THE INVENTION

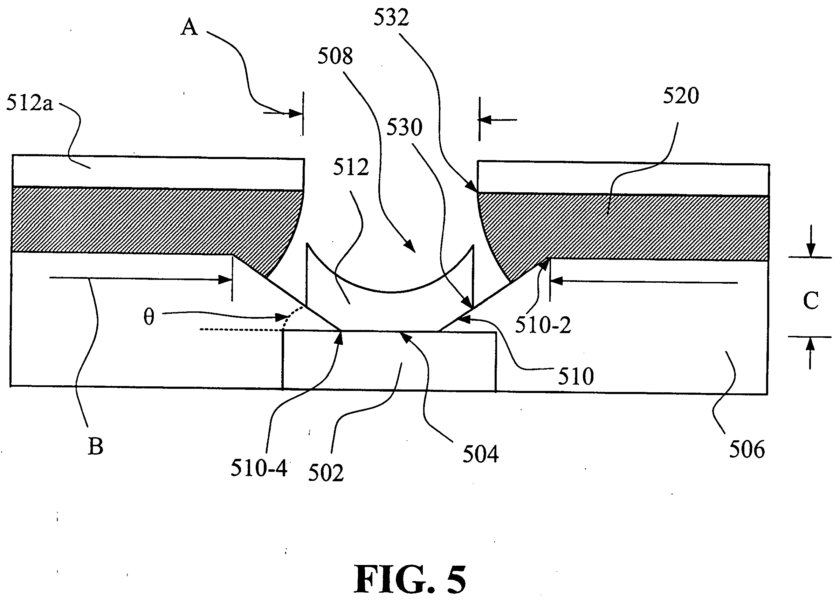

Please refer to FIG. 5, which depicts a diagram of a first embodiment of a via structure in a multi-layer substrate according to the present invention. In FIG. 5, only the related parts of the multi-layer substrate to the present invention are shown. The multi-layer substrate of the present invention comprises a first metal layer 502 having an upper surface 504. A dielectric layer 506 covers the first metal layer 502. The dielectric layer 506 is opened with a via 508 to expose the upper surface 504. The via 508 has an inclined wall 510. The inclined wall 510 has an upper edge 510-2. A second metal layer is formed in the via 508 as being a via land 512. The via land 512 contacts the upper surface 504 and with the inclined wall 510. A contacting surface of the via land 512 contacting with the upper surface 504 and the inclined wall 510 has a top line 530. The top line 530 is lower than the upper edge 510-2 of the inclined wall 510. Significantly, the size of via land 512 is smaller than the area enclosed by the upper edge 510-2 of the dielectric layer 506. The via land 512 is inside the via 508.

The materials of the first metal layer 502 and via land 512 (the second metal layer) can be copper. The material of the dielectric layer 506 can be PI (polyimide) and coated to cover the first metal layer 502. The second metal layer 512 can be formed inside the via 508 by metal lift-off process (More detail will be described later). Because the via land 512 of the via structure in the multi-layer substrate according to the present invention is located inside the via 508. Unlike prior arts that the via land size cannot be exactly defined by processes and hardly to be formed precisely on the inclined wall, i.e. the via wall, the via land size therefore, has to be larger than the via diameter. Comparing to prior arts, the present invention can further minify the via pitches and metal line pitches of the multi-layer substrate and significantly increase the routing density of the multi-layer substrate.

Furthermore, with the via land 512 which is formed in the via 508 by the metal lift-off process according to the present invention, the adhesion of the via land 512 to the first metal layer 502 and the inclined wall 510 of the dielectric layer 506 is well. Moreover, for approaching a smoother connection or contact between the via land 512 and the first metal layer 502, the inclined wall 510 of the dielectric layer 506, the via structure can have better pliability when the multi-layer substrate is bended. According to what the inventor tested and verified many times, the sharp angle formed by the upper surface 504 of the first metal layer 502 and the inclined wall 510, i.e. at the corner of the lower edge 510-4 is preferably less than 75°. Accordingly, the present invention still can maintain an original and complete via structure and without peeling or breaking, even the via structure is applied in the bendable areas in the flexible, bendable flexible print circuit boards or package substrates. The well electrical connection between the first metal layer 502 and the via land 512 still can be remained and therefore, raise the reliability of the multi-layer substrates.

The manufacturing method of the via structure by the metal lift-off process according to the present invention is described below:
forming a first metal layer 502;
forming a dielectric layer 506 to cover the first metal layer 502;
opening a via to expose the upper surface 504 of the first metal layer 502 and the via 508 has an inclined wall 510;
coating at least one photoresist layer 520 on a surface of the dielectric layer 506 and the upper surface 504;
proceeding a photolithography process to the photoresist layer 520;
removing the photoresist layer 520 in the via 508. For example, negative photoresist can be employed and developer is utilized to remove the photoresist layer 520 as shown in FIG. 5. The area enclosed by the upper edge 532 of the photoresist layer 520 can be controlled smaller than the area enclosed by the upper edge 510-2 of the inclined wall 510 and larger than the area enclosed by lower edge 510-4 of the inclined wall 510;
forming a second metal layer 512 in the via 508 and a second metal layer 512a on the photoresist layer 520 coated on the surface of the dielectric layer 506, wherein the second metal layer 512 in the via 508 contacts the upper surface 504 and the inclined wall 510; and
removing the photoresist layer 520 on the surface of the dielectric layer 506 and the second metal layer 512a formed on the photoresist layer 520.

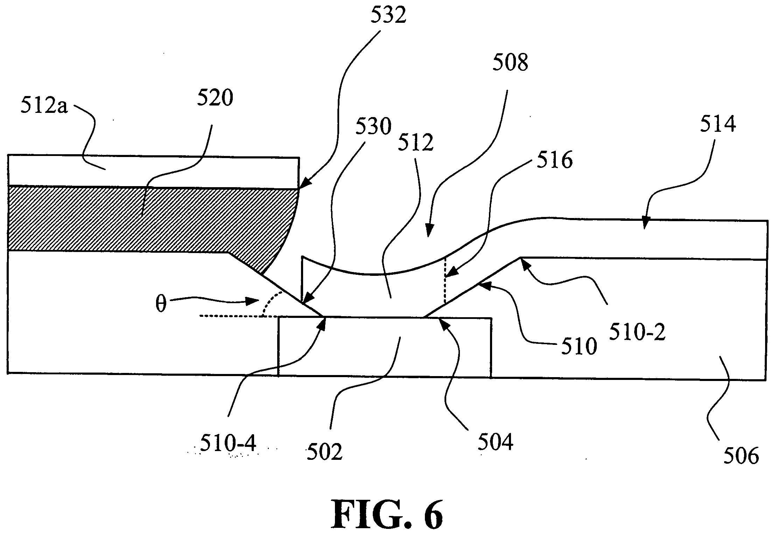

Herewith, the via structure of the present invention is accomplished. Significantly, in the present invention, the second metal layer formed in the via 508 is employed as being a via land 512. During the step of removing the photoresist layer 520 in the via 508, the photoresist layer 520 in a predetermined position on the surface of the dielectric layer 506 can be removed at the same time. As shown in FIG. 6, the second metal layer formed in the aforesaid predetermined position can be employed as being a metal line 514 and electrical connected with the via land 512. In the field of the present invention, photoresist layer 520 is defined by a mask with a photolithography process. The upper edge 532 of the open of the photoresist layer 520 is defined and trans-printed by a high precise photolithography process. Therefore, a advantage of the present invention better than prior arts is: the appearance and area are defined by the upper edge 532 of the open of the photoresist layer 520 on the surface of the dielectric layer 506 which is almost cognate with the size of the mask, i.e. the original design specification of the circuit. The present invention definitely gets rid of drawbacks of etching or semi-additive methods which lead the via size is unable to be defined precisely by the photoresist layer. Even facing more and more strict requirements of the metal lines and via structures, the present invention still can satisfy the coming demands of the multi-layer substrates today and in the near future.

For the related industry field of the fine pitch products today, the reasonable expected via depth is about 40 µm. The via diameter is about 40∼60 µm and the size limitation of the via land size is approaching 70 µm. On the contrary, with the present invention, the smallest and possible size of the via depth can approach to merely 3 µm. The via diameter can approach only 5 µm and the size limitation of the via land size can be as small as 7 µm .

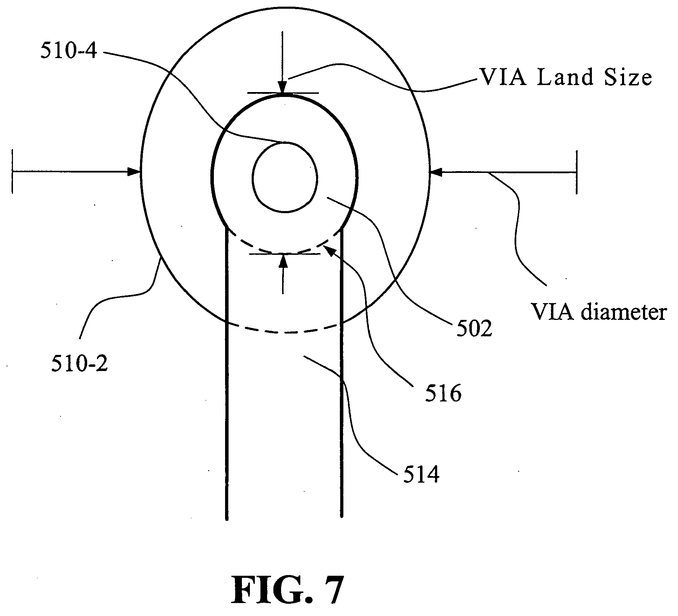

Please refer to FIG. 7 with FIG. 6. FIG. 6 depicts a diagram of a second embodiment of a via structure in a multi-layer substrate according to the present invention. FIG. 7 depicts a vertical view diagram of the second embodiment of the via structure in the multi-layer substrate according to the present invention. In FIG. 6, only the related parts of the multi-layer substrate to the present invention are shown. The multi-layer substrate of the present invention comprises a first metal layer 502 having an upper surface 504. A dielectric layer 506 covers the first metal layer 502. The dielectric layer 506 is opened with a via 508. The via 508 has an inclined wall 510. A second metal layer is formed in the via 508 as being a via land 512 and on the surface of the dielectric layer 506 as being a metal line 514. The via land 512 contacts with the upper surface 504 and with the inclined wall 510. A contacting surface of the via land 512 contacting with the upper surface 504 and the inclined wall 510 has a top line 530. The top line 530 is lower than the upper edge 510-2 of the inclined wall 510. Significantly, the size of via land 512 is smaller than the area enclosed by the upper edge 510-2 of the dielectric layer 506. The via land 512 is inside the via 508.

What's the second embodiment different from the first embodiment of the present invention is that the photoresist layer 520 in a predetermined position on the surface of the dielectric layer 506 can be removed at the same time as removing the photoresist layer 520 (not shown) in the via 508. The predetermined position can be formed for manufacturing a metal line 514 (such as a slot, not shown in figure). Afterward, the second metal layer is formed in the via 508 and in the predetermined position for as being the via land 512 and the metal line 514 respectively at the same time. Alternatively, different metal layers can be formed with different processes as being the via land 512 and the metal line 514 but still connected with each other. The electrical connection between different metal layers still can be accomplished. Similar as the first embodiment, a smoother connection or contact between the via land 512 and the first metal layer 502, the inclined wall 510 of the dielectric layer 506 can be realized. The connection between the via land 512 and the metal line 514 also can be smoother thereby. Besides, the metal line 514 also becomes smoother around the upper edge 510-2 and is still capable of remaining well pliability when the multi-layer substrate is bended herewith frequently. According to what the inventor tested and verified many times, the sharp angle formed by the upper surface 504 of the first metal layer 502 and the inclined wall 510, i.e. at the corner of the lower edge 510-4 is preferably less than 75°.

As shown in FIG. 7, the boundary between the via land 512 and the metal line 514 is the dot line 516 in general. According to the via structure in the multi-layer substrate of the present invention, the via land 512 is "inside" the via 508, i.e. smaller than the area enclosed the upper edge 510-2 and larger than the area enclosed by lower edge 510-4. Consequently, the via land 512 can be smaller than via diameter, therefore, the routing density can be increased. Meanwhile, with well connection (physically and electrically) between the via land 512 and the metal line 514, the possibility of peeling off or even breaking can be decreased. The present invention can further minify the size of the multi-layer substrates and significantly increase the routing density thereof. When the present invention is applied in the flexible print circuit boards and flexible package substrates which are both widely used in many aspects, the reliability of the boards or the substrates can be raised definitely.

As is understood by a person skilled in the art, the foregoing preferred embodiments of the present invention are intended to cover various modifications and similar arrangements which are within the scope of the appended claims.

## Claims

1. A via structure in a multi-layer substrate, **characterized in** comprising:
a first metal layer (502), having an upper surface (504);
a dielectric layer (506), covering the first metal layer (502) in which a via (508) is opened to expose the upper surface (504) and the via (508) has an inclined wall (510) with an upper edge (510-2); and
a second metal layer (512), formed in the via (508) as being a via land (512) which contacts the exposed upper surface (504) and the inclined wall (510), an electrical connection being formed between the via land (512) and the first metal layer (502), wherein a contacting surface of the via land (512) contacting with the exposed upper surface (504) and the inclined wall (510) has a top line (530) lower than the upper edge (510-2) of the inclined wall (510), the size of the via land (512) is smaller than the area enclosed by the upper edge (510-2) of the inclined wall (510), and the via land (512) is inside the via (508).

2. The via structure of claim 1, wherein the second metal layer (514) is further formed above the dielectric layer (506) employed as being a metal line and the second metal layer (512) in the via (508) is employed as being a pad, wherein the metal line and the pad are formed at the same time.

3. The via structure of claim 1, wherein an area formed by a lower edge (510-4) of the inclined wall (510) is smaller than an area formed by the upper edge (510-2).

4. The via structure of claim 1, wherein an acute angle θ formed by the upper surface (504) of the first metal layer (502) and the inclined wall (510) is smaller than 75°.

5. The via structure of claim 1, wherein the multi-layer substrate is flexible.

6. The via structure of claim 1, wherein a material of the first metal layer (502) is copper.

7. The via structure of claim 1, wherein a material of the second metal layer (512) is copper.

8. The via structure of claim 1, wherein a material of the dielectric layer (506) is polyimide.

9. The via structure of claim 1, wherein the second metal layer (512) is formed in the via (508) by a metal lift-off process.

10. A via structure in a multi-layer substrate, **characterized in** comprising:
a first metal layer (502), having an upper surface (504);
a dielectric layer (506), covering the first metal layer (502) in which a via (508) is opened to expose the upper surface (504) and the via (508) has an inclined wall (510) with an upper edge (510-2); and
a second metal layer (512), formed in the via (508) as being a pad and formed on the dielectric layer (506) as being a metal line, the second metal layer (512) as being the pad contacts the exposed upper surface (504) and the inclined wall (510), an electrical connection being formed between the pad of the second metal layer (512) and the first metal layer (502), a contacting surface of the pad contacting with the exposed upper surface (504) and the inclined wall (510) has a top line (530) lower than the upper edge (510-2) of the inclined wall (510).

11. The via structure of claim 10, **characterized in that** an area formed by a lower edge (510-4) of the inclined wall (510) is smaller than an area formed by the upper edge (510-2).

12. The via structure of claim 10, **characterized in that** an acute angle θ formed by the upper surface (504) of the first metal layer (502) and the inclined wall (510) is smaller than 75°.

13. The via structure of claim 10, **characterized in that** the multi-layer substrate is flexible.

14. The via structure of claim 10, **characterized in that** a material of the first metal layer (502) is copper.

15. The via structure of claim 10, **characterized in that** a material of the second metal layer (512) is copper.

16. The via structure of claim 10, **characterized in that** a material of the dielectric layer (506) is polyimide.

17. The via structure of claim 10, **characterized in that** the second metal layer (512) is formed in the via (508) by a metal lift-off process.

18. A manufacturing method of a via structure in a multi-layer substrate, **characterized in** comprising:
forming a first metal layer (502) having an upper surface (504);
forming a dielectric layer (506) to cover the first metal layer (502);
opening a via (508) to expose the upper surface (504) of the first metal layer (502) that the via (508) has an inclined wall (510) with an upper edge (510-2);
coating at least one photoresist layer (520) on a surface of the dielectric layer (506) and the upper surface (504) of the first metal layer (502) after the via (508) is manufactured to expose the upper surface (504);
proceeding a photolithography process to the photoresist layer (520);
removing the photoresist layer (520) in the via (508);
forming, after the step of removing the photoresist layer (520) in the via, a second metal layer (512, 512a) in the via (508) and on the photoresist layer (520) coated on the surface of the dielectric layer (506), and the second metal layer (512) in the via (508) contacts the upper surface (504) and the inclined wall (510), and a contacting surface of the second metal layer (512) has a top line (530); and
removing, after the step of forming the second metal layer (512, 512a) in the via (508) and on the photoresist layer (520), the photoresist layer (520) on the surface of the dielectric layer (506) and the second metal layer (512a) formed on the photoresist layer (520).

19. The manufacturing method of claim 18, **characterized in that** a shape and an area of the second metal layer (512) formed in the via (508) are defined by an upper edge (532) of the photoresist layer (520) coated on the surface of the dielectric layer (506).

20. The manufacturing method of claim 18, an area formed by a lower edge (510-4) of the inclined wall (510) is smaller than an area formed by the upper edge (510-2).

21. The manufacturing method of claim 18, an acute angle θ formed by the upper surface (504) of the first metal layer (502) and the inclined wall (510) is smaller than 75°.

22. The manufacturing method of claim 18, **characterized in that** an area formed by an upper edge (532) of the photoresist layer (520) coated on the surface of the dielectric layer (506) is between the areas formed by an upper edge (510-2) and a lower edge (510-4) of the inclined wall (510).

23. The manufacturing method of claim 18, further removing the photoresist layer (520) in a predetermined position on the surface of the dielectric layer (506) during the step of removing the photoresist layer (520) in the via (508), **characterized in that** the second metal layer (512) in the via (508) is employed as being a pad and the second metal layer (512a) formed in the predetermined position is employed as being a metal line.

24. The manufacturing method of claim 18, **characterized in that** a material of the first metal layer (502) is copper.

25. The manufacturing method of claim 18, **characterized in that** a material of the second metal layer (512) is copper.

26. The manufacturing method of claim 18, **characterized in that** a material of the dielectric layer (506) is polyimide.

## Patentansprüche

1. Via-Struktur in einem Mehrlagensubstrat, **dadurch gekennzeichnet, dass** sie Folgendes umfasst:
eine erste Metallschicht (502), die eine obere Oberfläche (504) aufweist;
eine dielektrische Schicht (506), die die erste Metallschicht (502) abdeckt, in welcher ein Via (508) geöffnet ist, um die obere Oberfläche (504) freizulegen, und das Via (508) eine schräge Wand (510) mit einer oberen Kante (510-2) aufweist; und
eine zweite Metallschicht (512), die im Via (508) als ein Via-Land (512) geformt ist, das die freiliegende obere Oberfläche (504) und die schräge Wand (510) kontaktiert, wobei eine elektrische Verbindung zwischen dem Via-Land (512) und der ersten Metallschicht (502) gebildet wird, worin eine Kontaktierungsoberfläche des Via-Lands (512), die mit der freiliegenden oberen Oberfläche (504) und der schrägen Wand (510) im Kontakt ist, eine obere Linie (530) aufweist, die niedriger als die obere Kante (510-2) der schrägen Wand (510) ist, die Größe des Via-Lands (512) kleiner als die Fläche ist, die von der oberen Kante (510-2) der schrägen Wand (510) umschlossen ist, und das Via-Land sich (512) innerhalb des Vias (508) befindet.

2. Via-Struktur nach Anspruch 1, worin die zweite Metallschicht (514) ferner über der dielektrischen Schicht (506) geformt ist, die als eine Metalllinie verwendet wird, und die zweite Metallschicht (512) im Via (508) als ein Pad verwendet wird, worin die Metalllinie und das Pad zur gleichen Zeit geformt werden.

3. Via-Struktur nach Anspruch 1, worin eine Fläche, die von einer unteren Kante (510-4) der schrägen Wand (510) gebildet ist, kleiner als eine Fläche ist, die von der oberen Kante (510-2) gebildet wird.

4. Via-Struktur nach Anspruch 1, worin ein spitzer Winkel θ, der von der oberen Oberfläche (504) der ersten Metallschicht (502) und von der schrägen Wand (510) gebildet wird, kleiner als 75° ist.

5. Via-Struktur nach Anspruch 1, worin das Mehrlagensubstrat flexibel ist.

6. Via-Struktur nach Anspruch 1, worin ein Material der ersten Metallschicht (502) Kupfer ist.

7. Via-Struktur nach Anspruch 1, worin ein Material der zweiten Metallschicht (512) Kupfer ist.

8. Via-Struktur nach Anspruch 1, worin ein Material der dielektrischen Schicht (506) Polyimid ist.

9. Via-Struktur nach Anspruch 1, worin die zweite Metallschicht (512) im Via (508) durch ein Metall-Lift-off-Verfahren gebildet wird.

10. Via-Struktur in einem Mehrlagensubstrat, **dadurch gekennzeichnet, dass** sie Folgendes umfasst:
eine erste Metallschicht (502), die eine obere Oberfläche (504) aufweist;
eine dielektrische Schicht (506), die die erste Metallschicht (502) abdeckt, in welcher ein Via (508) geöffnet ist, um die obere Oberfläche (504) freizulegen, und das Via (508) eine schräge Wand (510) mit einer oberen Kante (510-2) aufweist; und
eine zweite Metallschicht (512), die im Via (508) als ein Pad geformt ist, und über der dielektrischen Schicht (506) als eine Metalllinie geformt ist, wobei die zweite Metallschicht (512), die als Pad dient, die freiliegende obere Oberfläche (504) und die schräge Wand (510) kontaktiert, wobei eine elektrische Verbindung zwischen dem Pad der zweiten Metallschicht (512) und der ersten Metallschicht (502) gebildet wird, worin eine Kontaktierungsoberfläche des Pads, die mit der freiliegenden oberen Oberfläche (504) und der schrägen Wand (510) im Kontakt ist, eine obere Linie (530) aufweist, die niedriger als die obere Kante (510-2) der schrägen Wand (510) ist.

11. Via-Struktur nach Anspruch 10, **dadurch gekennzeichnet, dass** eine Fläche, die von einer unteren Kante (510-4) der schrägen Wand (510) gebildet ist, kleiner als eine Fläche ist, die von der oberen Kante (510-2) gebildet wird.

12. Via-Struktur nach Anspruch 10, **dadurch gekennzeichnet, dass** ein spitzer Winkel θ, der von der oberen Oberfläche (504) der ersten Metallschicht (502) und von der schrägen Wand (510) gebildet wird, kleiner als 75° ist.

13. Via-Struktur nach Anspruch 10, **dadurch gekennzeichnet, dass** das Mehrlagensubstrat flexibel ist.

14. Via-Struktur nach Anspruch 10, **dadurch gekennzeichnet, dass** ein Material der ersten Metallschicht (502) Kupfer ist.

15. Via-Struktur nach Anspruch 10, **dadurch gekennzeichnet, dass** ein Material der zweiten Metallschicht (512) Kupfer ist.

16. Via-Struktur nach Anspruch 10, **dadurch gekennzeichnet, dass** ein Material der dielektrischen Schicht (506) Polyimid ist.

17. Via-Struktur nach Anspruch 10, **dadurch gekennzeichnet, dass** die zweite Metallschicht (512) im Via (508) durch ein Metall-Lift-off-Verfahren gebildet wird.

18. Herstellungsverfahren einer Via-Struktur in einem Mehrlagensubstrat, **dadurch gekennzeichnet, dass** es Folgendes umfasst:
das Bilden einer ersten Metallschicht (502), die eine obere Oberfläche (504) aufweist;
das Bilden einer dielektrischen Schicht (506), um die erste Metallschicht (502) abzudecken;
das Öffnen eines Vias (508), um die obere Oberfläche (504) der ersten Metallschicht (502) freizulegen, so dass das Via (508) eine schräge Wand (510) mit einer oberen Kante (510-2) aufweist;
das Beschichten mindestens einer Photolackschicht (520) auf einer Oberfläche der dielektrischen Schicht (506) und über der oberen Oberfläche (504) der ersten Metallschicht (502), nachdem das Via (508) hergestellt wird, um die obere Oberfläche (504) freizulegen;
das Vorgehen mit einem photolitographischen Verfahren auf der Photolackschicht (520);
das Entfernen der Photolackschicht (520) im Via (508);
das Bilden, nach dem Schritt des Entfernens der Photolackschicht (520) im Via (508), einer zweiten Metallschicht (512, 512a) im Via (508) und auf der Photolackschicht (520), die auf Oberfläche der dielektrischen Schicht (506) beschichtet wird, und der zweiten Metallschicht (512) im Via (508) die obere Oberfläche (504) und die schräge Wand (510) kontaktiert, und eine Kontaktierungsoberfläche der zweiten Metallschicht (512) eine obere Linie (530) aufweist; und
das Entfernen, nach dem Schritt des Bildens der zweiten Metallschicht (512, 512a) im Via (508) und auf der Photolackschicht (520), der Photolackschicht (520) auf der Oberfläche der dielektrischen Schicht (506) und der zweiten Metallschicht (512a), die auf der Photolackschicht (520) gebildet ist.

19. Herstellungsverfahren nach Anspruch 18, **dadurch gekennzeichnet, dass** eine Form und eine Fläche der zweiten Metallschicht (512), die im Via (508) gebildet ist, von einer oberen Kante (532) der Photolackschicht (520) definiert werden, die auf der Oberfläche der dielektrischen Schicht (506) beschichtet wird.

20. Herstellungsverfahren nach Anspruch 18, eine Fläche, die von einer unteren Kante (510-4) der schrägen Wand (510) gebildet ist, ist kleiner als eine Fläche, die von der oberen Kante (510-2) gebildet wird.

21. Herstellungsverfahren nach Anspruch 18, ein spitzer Winkel θ, der von der oberen Oberfläche (504) der ersten Metallschicht (502) und von der schrägen Wand (510) gebildet wird, ist kleiner als 75°.

22. Herstellungsverfahren nach Anspruch 18, **dadurch gekennzeichnet, dass** eine Fläche, die von einer oberen Kante (532) der Photolackschicht (520), die auf der Oberfläche der dielektrischen Schicht (506) beschichtet wird, zwischen den Flächen liegt, die von einer oberen Kante (510-2) und von einer unteren Kante (510-4) der schrägen Wand (510) gebildet sind.

23. Herstellungsverfahren nach Anspruch 18, das ferner die Photolackschicht (520) in einer vorbestimmten Stellung auf der Oberfläche der dielektrischen Schicht (506) während des Schritts des Entfernens der Photolackschicht (520) im Via (508) entfernt, **dadurch gekennzeichnet, dass** die zweite Metallschicht (514) im Via (508) als Pad verwendet wird, und die zweite Metallschicht (512a), die in der vorbestimmten Stellung gebildet wird, als Metalllinie verwendet wird.

24. Herstellungsverfahren nach Anspruch 18, **dadurch gekennzeichnet, dass** ein Material der ersten Metallschicht (502) Kupfer ist.

25. Herstellungsverfahren nach Anspruch 18, **dadurch gekennzeichnet, dass** ein Material der zweiten Metallschicht (512) Kupfer ist.

26. Herstellungsverfahren nach Anspruch 18, **dadurch gekennzeichnet, dass** ein Material der dielektrischen Schicht (506) Polyimid ist.

## Revendications

1. Structure de trou d'interconnexion dans un substrat multicouche, **caractérisée en ce qu'**elle comprend : une première couche métallique (502) ayant une surface supérieure (504) ;
une couche diélectrique (506), recouvrant la première couche métallique (502) dans laquelle est formé un trou d'interconnexion (508) pour découvrir la surface supérieure (504) et le trou d'interconnexion (508) comporte une paroi inclinée (510) avec un bord supérieur (510-2) ; et
une seconde couche métallique (512), formée dans le trou d'interconnexion (508) en forme de zone d'interconnexion (512), venant en contact avec la surface supérieure découverte (504) et la paroi inclinée (510), une connexion électrique étant établie entre la zone d'interconnexion (512) et la première couche métallique (502), dans laquelle une surface de contact de la zone d'interconnexion (512), en contact avec la surface supérieure découverte (504) et la paroi inclinée (510) a une ligne de sommet (530) inférieure au bord supérieur (510-2) de la paroi inclinée (510), les dimensions de la zone d'interconnexion (512) sont inférieures à celles de la zone renfermée par le bord supérieur (510-2) de la paroi inclinée (510), et la zone d'interconnexion (512) est à l'intérieur du trou d'interconnexion (508).

2. Structure de trou d'interconnexion selon la revendication 1, dans laquelle la seconde couche métallique (514) est par ailleurs formée au-dessus de la couche diélectrique (506) employée en forme de ligne métallique et la seconde couche métallique (512) dans le trou d'interconnexion (508) est employée en forme de pastille, dans laquelle la ligne métallique et la pastille sont formées en même temps.

3. Structure de trou d'interconnexion selon la revendication 1, dans laquelle une région formée par un bord inférieur (510-4) de la paroi inclinée (510) est plus petite qu'une région formée par le bord supérieur (510-2).

4. Structure de trou d'interconnexion selon la revendication 1, dans laquelle un angle aigu θ formé par la surface supérieure (504) de la première couche métallique (502) et la paroi inclinée (510) est inférieur à 75°.

5. Structure de trou d'interconnexion selon la revendication 1, dans laquelle le substrat multicouche est flexible.

6. Structure de trou d'interconnexion selon la revendication 1, dans laquelle un matériau de la première couche métallique (502) est le cuivre.

7. Structure de trou d'interconnexion selon la revendication 1, dans laquelle un matériau de la seconde couche métallique (512) est le cuivre.

8. Structure de trou d'interconnexion selon la revendication 1, dans laquelle un matériau de la couche diélectrique (506) est le polyimide.

9. Structure de trou d'interconnexion selon la revendication 1, dans laquelle la seconde couche métallique (512) est formée dans le trou d'interconnexion (508) par un procédé dit de lift-off de métal.

10. Structure de trou d'interconnexion dans un substrat multicouche, **caractérisée en ce qu'**elle comprend : une première couche métallique (502) ayant une surface supérieure (504) ;
une couche diélectrique (506), recouvrant la première couche métallique (502) dans laquelle est formé un trou d'interconnexion (508) pour découvrir la surface supérieure (504) et le trou d'interconnexion (508) comporte une paroi inclinée (510) avec un bord supérieur (510-2) ; et
une seconde couche métallique (512), formée dans le trou d'interconnexion (508) en forme de pastille et formée sur la couche diélectrique (506) en forme de ligne métallique, la seconde couche métallique (512) en forme de pastille venant en contact avec la surface supérieure découverte (504) et la paroi inclinée (510), une connexion électrique étant établie entre la pastille de la seconde couche métallique (512) et la première couche métallique (502), une surface de contact de la pastille en contact avec la surface supérieure découverte (504) et la paroi inclinée (510) a une ligne de sommet (530) inférieure au bord supérieur (510-2) de la paroi inclinée (510).

11. Structure de trou d'interconnexion selon la revendication 10, **caractérisée en ce qu'**une région formée par un bord inférieur (510-4) de la paroi inclinée (510) est plus petite qu'une région formée par le bord supérieur (510-2).

12. Structure de trou d'interconnexion selon la revendication 10, **caractérisée en ce qu'**un angle aigu θ formé par la surface supérieure (504) de la première couche métallique (502) et la paroi inclinée (510) est inférieur à 75°.

13. Structure de trou d'interconnexion selon la revendication 10, **caractérisée en ce que** le substrat multicouche est flexible.

14. Structure de trou d'interconnexion selon la revendication 10, **caractérisée en ce qu'**un matériau de la première couche métallique (502) est le cuivre.

15. Structure de trou d'interconnexion selon la revendication 10, **caractérisée en ce qu'**un matériau de la seconde couche métallique (512) est le cuivre.

16. Structure de trou d'interconnexion selon la revendication 10, **caractérisée en ce qu'**un matériau de la couche diélectrique (506) est le polyimide.

17. Structure de trou d'interconnexion selon la revendication 10, **caractérisé en ce que** la seconde couche métallique (512) est formée dans le trou d'interconnexion (508) par un procédé dit de lift-off de métal.

18. Procédé de fabrication d'une structure de trou d'interconnexion dans un substrat multicouche, **caractérisé en ce qu'**il comprend les étapes suivantes :
former une première couche métallique (502) ayant une surface supérieure (504) ; former une couche diélectrique (506) pour recouvrir la première couche métallique (502) ;
former un trou d'interconnexion (508) pour découvrir la surface supérieure (504) de la première couche métallique (502), le trou d'interconnexion (508) ayant une paroi incliné (510) avec un bord supérieur (510-2) ;
appliquer au moins une couche de résine photosensible (520) sur une surface de la couche diélectrique (506) et la surface supérieure (504) de la première couche métallique (502) après la fabrication du trou d'interconnexion (508) pour découvrir la surface supérieure (504) ;
effectuer un procédé de photolithographie sur la couche de résine photosensible (520) ; enlever la couche de résine photosensible (520) dans le trou d'interconnexion (508) ;
former, après l'étape d'enlever la couche de résine photosensible (520) dans le trou d'interconnexion, une seconde couche métallique (512, 512a) dans le trou d'interconnexion (520) et sur la couche de résine photosensible (520) appliquée sur la surface de la couche diélectrique (506), la seconde couche métallique (512) dans le trou d'interconnexion (508) venant en contact avec la surface supérieure (504) et la paroi inclinée (510), et une surface de contact de la seconde couche métallique (512) ayant une ligne de sommet (530) ; et
enlever, après l'étape de former la seconde couche métallique (512, 512a) dans le trou d'interconnexion (508) et sur la couche de résine photosensible (520), la couche de résine photosensible (520) sur la surface de la couche diélectrique (506) et la seconde couche métallique (512a) formée sur la couche de résine photosensible (520).

19. Procédé de fabrication selon la revendication 18, **caractérisé en ce qu'**une forme et une région de la seconde couche métallique (512) formée dans le trou d'interconnexion (508) sont définies par un bord supérieur (532) de la couche de résine photosensible (520) appliquée sur la surface de la couche diélectrique (506).

20. Procédé de fabrication selon la revendication 18, une région formée par un bord inférieur (510-4) de la paroi inclinée (510) est plus petite qu'une région formée par le bord supérieur (510-2).

21. Procédé de fabrication selon la revendication 18, un angle aigu θ formé par la surface supérieure (504) de la première couche métallique (502) et la paroi inclinée (510) est inférieur à 75°.

22. Procédé de fabrication selon la revendication 18, **caractérisé en ce qu'**une région formée par un bord supérieur (532) de la couche de résine photosensible (520) appliquée sur la surface de la couche diélectrique (506) se trouve entre les régions formées par un bord supérieur (510-2) et un bord inférieur (510-4) de la paroi inclinée (510).

23. Procédé de fabrication selon la revendication 18, enlevant par ailleurs la couche de résine photosensible (520) dans une position préétablie sur la surface de la couche diélectrique (506) pendant l'étape d'enlever la couche de résine photosensible (520) dans le trou d'interconnexion (508), **caractérisé en ce que** la seconde couche métallique (512) dans le trou d'interconnexion (512a) formée dans la position préétablie est employée en forme de ligne métallique.

24. Procédé de fabrication selon la revendication 18, **caractérisé en ce qu'**un matériau de la première couche métallique (502) est le cuivre.

25. Procédé de fabrication selon la revendication 18, **caractérisé en ce qu'**un matériau de la seconde couche métallique (512) est le cuivre.

26. Procédé de fabrication selon la revendication 18, **caractérisé en ce qu'**un matériau de la couche diélectrique (506) est le polyimide.
